# EUROPÄISCHE PATENTSCHRIFT

(11) **EP 3 170 366 B1**
(45) Veröffentlichungstag und Bekanntmachung des Hinweises auf die Patenterteilung: **27.06.2018**
(21) Anmeldenummer: 15736835.8
(22) Anmeldetag: 14.07.2015
(51) Int. Cl.: H05B 7/00, F27B 3/28, G01R 31/02, H05B 7/02, H05B 7/148

(54) **ELEKTRISCHER LICHTBOGENOFEN MIT EINER SICHERHEITSVORRICHTUNG UND VERFAHREN ZUR SICHERUNG VON PERIPHERIEGERÄTEN AN ELEKTRISCHEN LICHTBOGENÖFEN**
ELECTRIC ARC FURNACE COMPRISING A SAFETY DEVICE, AND A METHOD FOR PROTECTING PERIPHERAL DEVICES ON ELECTRIC ARC FURNACES
FOUR À ARC ÉLECTRIQUE COMPORTANT UN DISPOSITIF DE SÉCURITÉ ET PROCÉDÉ DE SÉCURISATION D'APPAREILS PÉRIPHÉRIQUES SUR UN FOUR À ARC ÉLECTRIQUE

(30) Priorität: 15.07.2014 DE 102014213744
(43) Veröffentlichungstag der Anmeldung: 24.05.2017
(73) Patentinhaber: Primetals Technologies Germany GmbH, 91052 Erlangen (DE)
(72) Erfinder: HARTMANN, Werner, 91085 Weisendorf (DE); HAVERKAMP, Vico, 22179 Hamburg (DE); HERGT, Martin, 90411 Nürnberg (DE); KRÜGER, Klaus, 83416 Saaldorf-Surheim (DE); MATSCHULLAT, Thomas, 90542 Eckental (DE)
(74) Vertreter: Metals@Linz
(86) Internationale Anmeldenummer: PCT/EP2015/066014
(87) Internationale Veröffentlichungsnummer: WO 2016/008864

(56) Entgegenhaltungen:
- EP-A1- 0 291 156
- EP-A1- 0 866 139
- JP-A- H11 201 662
- US-A- 4 161 618
- US-A- 4 223 306

## Beschreibung

Die Erfindung betrifft einen elektrischen Lichtbogenofen mit einer Sicherheitsvorrichtung nach Patentanspruch 1. 1 sowie ein Verfahren zur Sicherung von Peripheriegeräten an einem elektrischen Lichtbogenofen nach Patentanspruch 4.

Dokument EP 0 866 139 offenbart einen elektrischen Lichtbogenofen nach dem Oberbegriff des Patentanspruchs 1. Elektrolichtbogenöfen werden bei der Herstellung von Stahl und anderen Metallen benutzt, um Schrott und andere eisenhaltige Materialien beziehungsweise Nickel oder auch Chrom einzuschmelzen. Häufig wird beim Einschmelzvorgang ein Teil der notwendigen thermischen Energie durch einen Gasbrenner eingebracht, um den Einschmelzvorgang zu beschleunigen, ohne die elektrische Anschlussleistung des Lichtbogenofens erhöhen zu müssen. Für das Einbringen von anderen Stoffen, wie zum Beispiel von Stäuben oder von Sauerstoff zum Frischen der Schmelze, werden ebenfalls Gaszuführungsrohre, sogenannte Lanzen oder Injektoren, benötigt. In einigen Fällen werden zusätzlich auch elektrische Brenner, sogenannte Plasmabrenner, eingesetzt, um die notwendige Prozesswärme in den Ofen einzubringen. Aus Gründen der elektrischen Anlagensicherheit müssen alle diese sowie gegebenenfalls noch weitere Peripheriegeräte im Außenbereich des Lichtbogenofens separat geerdet werden, um im Betrieb das Auftreten gefährlicher Berührungsspannungen an diesen Teilen und den zugehörigen Leitungen beziehungsweise Befestigungsstrukturen zu verhindern. Diese Peripheriegeräte mit ihren Leitungen und Befestigungsstrukturen liegen daher im Allgemeinen auf einem von der Ofenwand und insbesondere dem Schmelzgut unterschiedlichen elektrischen Potential. Dadurch kommt es im Betrieb des Lichtbogenofens gelegentlich dazu, dass ein Teillichtbogen von der Schmelze, beziehungsweise dem einzuschmelzenden Gut, oder einer der Lichtbogenelektroden auf diese Anlagenteile beziehungsweise Peripheriegeräte zündet und ein erheblicher Strom von mehreren Kiloampere Amplituden über die Erdung abfließen kann. Insbesondere kann dies dadurch ausgelöst werden, dass einzuschmelzender Schrott im Schrotthaufwerk umfällt oder weggeschleudert wird und in die Nähe des Brenners oder der Lanze kommt, so dass ein Störlichtbogen zünden kann. Dies kann zu schweren Schäden an den genannten Peripheriegeräten führen. Daraus entsteht zudem ein erhebliches Gefährdungspotential z.B. durch Dampfexplosionen im Lichtbogenofen, wenn durch den Lichtbogenofen die Kühlwasserführung der Brenner oder eines Panels durchbrochen wird und Kühlwasser in den Lichtbogenofen gelangt.

Bisher wird daher der Wasserdruck und/oder die Rücklauftemperatur von Kühlwasser aus den genannten Peripheriegeräten oder aus einem Panel überwacht. Bei auftretenden Problemen wird der Ofen abgeschaltet und die Kühlwasserzufuhr abgedreht. Durch die genannten Methoden entsteht jedoch häufig eine relativ langwierige Reaktionszeit, um auf entstehende Teillichtbögen zu reagieren, was zu Schäden an den Peripheriegeräten führen kann. Ferner wird durch das Abschalten des Lichtbogenofens ein erheblicher Produktionsausfall herbeigeführt.

Die Aufgabe der Erfindung besteht darin, einen elektrischen Lichtbogenofen mit einer entsprechenden Sicherheitsvorrichtung sowie ein Verfahren zur Sicherung eines Lichtbogenofens bereitzustellen, die gegenüber dem Stand der Technik einen besseren Schutz von Peripheriegeräten darstellen. Ferner sollen die Ausfallzeiten des Lichtbogenofens während des Prozesses minimiert werden.

Die Lösung der Aufgabe besteht in einem elektrischen Lichtbogenofen mit einer Sicherheitsvorrichtung mit den Merkmalen des Patentanspruchs 1 sowie in einem Verfahren zur Sicherung von Peripheriegeräten an einem elektrischen Lichtbogenofen mit den Merkmalen des Patentanspruchs 4.

Der elektrische Lichtbogenofen nach Anspruch 1 weist eine Sicherheitsvorrichtung sowie mindestens ein geerdetes Peripheriegerät auf. Der Lichtbogenofen zeichnet sich dadurch aus, dass eine Erdungsleitung zu dem Peripheriegerät vorgesehen ist, und dass zudem ein Strommessgerät zur Messung des Stromes an der Erdungsleitung vorhanden ist. Ferner umfasst die Vorrichtung einen Schutzschalter, der in der Erdungsleitung angeordnet ist und daher eine Auslösezeit von weniger als 100 ms aufweist.

Es erfolgt somit eine kontinuierliche Überwachung des Stromes in der Erdungsleitung, wobei bei Auftreten eines Teillichtbogens zwischen der Schmelze oder einem Schrottteil und dem Peripheriegerät dieser Strom in der Erdungsleitung naturgemäß sehr schnell ansteigt, wobei ein Auslösen des Sicherheitsschalters in weniger als 100 ms, bevorzugt in weniger als 10 ms, erfolgt. Somit wird die Erdung kurzzeitig, bevorzugt nur für weniger als eine Sekunde, unterbrochen, sodass der Teillichtbogen, der sich zwischen dem Peripheriegerät und dem Schmelzgut kurzzeitig aufgebaut hat, sofort wieder erlischt. Hierdurch wird eine Gefährdung des Peripheriegerätes bereits in den Ansätzen unterbunden, da die zur nachhaltigen Schädigung notwendige Energiemenge nicht erreicht wird. Ein Abschalten des Gesamtlichtbogenofens kann unterbleiben.

Besonders vorteilhaft ist es, wenn das Strommessgerät bereits im Schutzschalter integriert ist, da so die Reaktionszeiten des Schutzschalters noch weiter verringert werden können.

Die Peripheriegeräte des Lichtbogenofens sind insbesondere eine Lanze, ein Injektor beziehungsweise ein Brenner, es können auch Kühlpanele des Lichtbogenofens durch die erfindungsgemäße Vorrichtung geschützt werden.

Eine weitere Ausgestaltungsform der Erfindung zeichnet sich dadurch aus, dass das Peripheriegerät des Lichtbogenofens (2) ein elektrisch betriebener Plasmabrenner (10) oder -injektor ist, der als äußere Schicht eine elektrisch gegenüber den anderen Brennerteilen isolierte Metallhülle aufweist, wobei ausschließlich die isolierte Metallhülle mit der Sicherungsvorrichtung elektrisch verbunden ist.

Ein weiterer Bestandteil der Erfindung ist ein Verfahren zur Sicherung von Peripheriegeräten an einem elektrischen Lichtbogenofen nach Patentanspruch 4. Dieses Verfahren zeichnet sich dadurch aus, dass eine Erdungsleitung an dem Peripheriegerät vorgesehen ist und ein Stromfluss durch die Erdungsleitung gemessen wird, um bei Auftreten einer kritischen Stromstärke die Erdungsleitung durch einen Schutzschalter innerhalb von 100 ms unterbrochen wird.

Durch das erfindungsgemäße Verfahren ergeben sich dieselben Vorteile, die bereits bezüglich der Vorrichtung gemäß Patentanspruch 1 beschrieben sind.

Anhand der folgenden Figur soll eine beispielhafte Ausgestaltungsform der Erfindung näher erläutert werden. Hierbei handelt es sich um eine vereinfacht dargestellte allgemeine Ausgestaltungsform der Erfindung, die keine Einschränkung des Schutzbereichs darstellt.

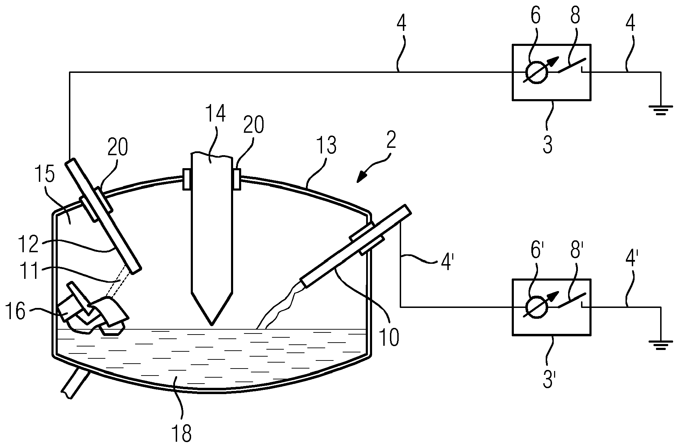

Die einzige Figur zeigt einen Lichtbogenofen mit Peripheriegeräten und Sicherheitsvorrichtungen.

Ein Lichtbogenofen 2 weist eine Elektrode 14 auf, die durch eine Isolierung 20 in einer Decke 13 des Lichtbogenofens 2 in einen Innenraum 15 des Lichtbogenofens 2 eingeführt wird und zur Übertragung von elektrischem Strom zur Aufheizung von Schmelzgut 16 führt. Ferner sind verschiedene Peripheriegeräte exemplarisch und schematisch eingezeichnet, hierbei handelt es sich zum einen um einen Gasbrenner 10, der zur zusätzlichen Aufheizung des Schmelzgutes 16 und zur Überführung des Schmelzgutes 16 in die Schmelze 18 dient. Ferner ist schematisch eine Sauerstofflanze 20 dargestellt, die zum Einbringen von Sauerstoff in die Schmelze dient. Sowohl der Brenner 10 als auch die Lanze 12 sind durch Isolierungen in der gekühlten Decke 13 des Lichtbogenofens 2 eingeführt.

Die Peripheriegeräte, hier am Beispiel des Brenners 10 und der Lanze 12 veranschaulicht, sind gegenüber dem Lichtbogenofen 2 elektrisch isoliert, weshalb sie aus Sicherheitsgründen separat durch eine Erdungsleitung 4 geerdet sind. In der Erdungsleitung 4 beziehungsweise 4' ist eine Sicherheitsvorrichtung 3 beziehungsweise 3' vorgesehen, die in Form eines Schutzschalters 8 sowie einem integrierten Strommessgerät 6 ausgestaltet ist. Bei Auftreten eines, durch die gestrichelte Linie 11 zwischen dem Schmelzgut 16 und der Lanze 12 schematisch angedeuteten, Teillichtbogens 11 fließt ein erheblicher Strom durch die Erdungsleitung 4, der durch das Strommessgerät 6 detektiert wird und ein Öffnen des Schutzschalters 8 in weniger als 100 ms, bevorzugt in weniger als 10 ms, bewirkt. Die Erdungsleitung 4, 4' wird somit innerhalb von wenigen Millisekunden aufgehoben und der Teillichtbogen 11 bricht zusammen, bevorzugt bevor er sich vollständig aufgebaut hat. Somit wird eine Schädigung des Peripheriegerätes, in diesem Beispiel der Lanze 12, durch sofortige Unterbrechung der Erdungsleitung verhindert.

Die Erdungsleitung wird dabei bevorzugt nur kurzzeitig, also nur wenige Sekunden, unterbrochen, gerade ausreichend lang, damit der Störlichtbogen verlöschen kann, so dass keine Primär- oder Sekundärschäden auf dem anderen Peripheriegerät auftreten können. Die Erdungsleitung 4 wird vorzugsweise in Nähe des Lichtbogenofens 2 mit dem entsprechenden Schutzschalter 8 beziehungsweise der Sicherheitsvorrichtung 3 versehen. Im Störfall, also beim Auftreten eines Störlichtbogens 11 gegen die gefährdeten Peripherieteile, wird der Lichtbogenstrom, der gegen Erde durch den Schutzschalter 8 abfließt, innerhalb von wenigen Millisekunden begrenzt und dann unterbrochen, wodurch Primärschäden auch an einer Kühlmittelführung in der Decke 13 des Lichtbogenofens 2 vermieden werden, wodurch auch ein Aufschweißen dieser Kühlmittelführung, die in der Figur nicht näher dargestellt ist, vermieden wird. Hierdurch entsteht auch eine höhere Sicherheit bezüglich möglicher Dampfexplosionen, die durch Austreten des Kühlwassers hervorgerufen werden könnten.

Es ist ferner zweckmäßig, dass der Schutzschalter 8 beziehungsweise die Sicherungsvorrichtung 3 insgesamt in der Erdungsleitung 4 so weit in Ofennähe angebracht ist, so dass im Betrieb keine Berührung der kurzzeitig nicht geerdeten Anlagenteile durch Personen möglich ist. Die Gaszuleitungen zu den Peripheriegeräten müssen zumindest über kurze Strecken von mindestens einigen Zentimetern ausreichend zur Isolation der entsprechenden Spannungen von einigen 100 V bis zu 1 kV isoliert zugeführt werden und außerhalb dieses Bereiches wieder berührungssicher geerdet werden.

### Bezugszeichenliste

- 2: Lichtbogenofen
- 3: Sicherheitsvorrichtung
- 4: Erdungsleitung
- 6: Strommessgerät
- 8: Schutzschalter
- 10: Brenner
- 11: Teillichtbogen
- 12: Sauerstofflanze
- 13: gekühlte Decke
- 14: Elektrode
- 15: Innenraum
- 16: Schrott
- 18: Schmelze
- 20: Isolierung

## Patentansprüche

1. Elektrischer Lichtbogenofen mit einer Sicherheitsvorrichtung (3) und einem geerdeten Peripheriegerät, **dadurch gekennzeichnet, dass** eine Erdungsleitung (4) zu dem Peripheriegerät des Lichtbogenofens (2) sowie ein Strommessgerät (6) zur Messung des Stroms an der Erdungsleitung (4) vorgesehen sind und dass ein Schutzschalter (8) in der Erdungsleitung (4) vorgesehen ist, der eine Auslösezeit von weniger als 100 ms aufweist.

2. Elektrischer Lichtbogenofen nach Anspruch 1, **dadurch gekennzeichnet, dass** das Strommessgerät (6) im Schutzschalter (8) integriert ist.

3. Elektrischer Lichtbogenofen nach Anspruch 1 oder 2, **dadurch gekennzeichnet, dass** das Peripheriegerät des Lichtbogenofens (2) eine Lanze (12), ein Brenner (10) oder ein Injektor ist.

4. Elektrischer Lichtbogenofen nach einem der vorhergehenden Ansprüchen, **dadurch gekennzeichnet, dass** das Peripheriegerät des Lichtbogenofens (2) ein elektrisch betriebener Plasmabrenner (10) oder -injektor ist, der als äußere Schicht eine elektrisch gegenüber den anderen Brennerteilen isolierte Metallhülle aufweist, wobei ausschließlich die isolierte Metallhülle mit der Schutzeinrichtung elektrisch verbunden ist.

5. Verfahren zur Sicherung von Peripheriegeräten an einem elektrischen Lichtbogenofen (2), **dadurch gekennzeichnet, dass** eine Erdungsleitung (4) an dem Peripheriegerät vorgesehen ist und ein Stromfluss durch die Erdungsleitung (4) gemessen wird und bei Auftreten einer kritischen Stromstärke die Erdungsleitung (4) durch einen Schutzschalter innerhalb von 100 ms unterbrochen wird.

## Claims

1. Electric arc furnace having a safety device (3) and an earthed peripheral device, **characterized in that** an earth line (4) to the peripheral device of the arc furnace (2) and an ammeter (6) for measuring the current in the earth line (4) are provided, and **in that** there is provided in the earth line (4) a safety switch (8) having a tripping time of less than 100 ms.

2. Electric arc furnace according to Claim 1, **characterized in that** the ammeter (6) is integrated into the safety switch (8) .

3. Electric arc furnace according to Claim 1 or 2, **characterized in that** the peripheral device of the arc furnace (2) is a lance (12), a burner (10) or an injector.

4. Electric arc furnace according to one of the preceding claims, **characterized in that** the peripheral device of the arc furnace (2) is an electrically operated plasma burner (10) or plasma injector which has, as its outer layer, a metal shell which is electrically insulated from the other burner parts, only the insulated metal shell being electrically connected to the safety device.

5. Method for protecting peripheral devices on an electric arc furnace (2), **characterized in that** an earth line (4) is provided on the peripheral device, and a flow of current through the earth line (4) is measured, and in the event of a critical current magnitude, the earth line (4) is broken by a safety switch within 100 ms.

## Revendications

1. Four à arc électrique avec un dispositif de sécurité (3) et un appareil périphérique mis à la terre, **caractérisé en ce qu'**un conducteur de terre (4) est prévu sur l'appareil périphérique du four à arc (2) et un ampèremètre (6) afin de mesurer le courant sur le conducteur de terre (4) est prévu et **en ce qu'**un disjoncteur (8) est prévu sur le conducteur de terre (4), lequel disjoncteur présente une durée de déclenchement inférieure à 100 ms.

2. Four à arc électrique selon la revendication 1, **caractérisé en ce que** l'ampèremètre (6) est intégré au disjoncteur (8).

3. Four à arc électrique selon la revendication 1 ou 2, **caractérisé en ce que** l'appareil périphérique du four à arc (2) est une lance (12), une torche (10) ou un injecteur.

4. Four à arc électrique selon l'une des revendications précédentes, **caractérisé en ce que** l'appareil périphérique du four à arc (2) est une torche ou un injecteur à plasma électrique (10), qui présente en guise de couche extérieure une enveloppe métallique isolée électriquement par rapport aux autres parties de la torche, dans lequel seule l'enveloppe métallique isolée est en contact électrique avec le dispositif de protection.

5. Procédé de sécurisation d'appareils périphériques sur un four à arc électrique (2), **caractérisé en ce qu'**un conducteur de terre (4) est prévu sur l'appareil périphérique et un flux de courant traversant le conducteur de terre (4) est mesuré et un disjoncteur interrompt le conducteur de terre dans un délai de 100 ms lors de la survenue d'une intensité de courant critique.
